# EUROPÄISCHE PATENTANMELDUNG

(11) **EP 4 417 730 A1**
(43) Veröffentlichungstag der Anmeldung: **21.08.2024**
(21) Anmeldenummer: 23212966.8
(22) Anmeldetag: 29.11.2023
(51) Int. Cl.: C23C 16/04, C23C 16/448, C23C 16/455, C23C 16/511

(54) **VORRICHTUNG UND VERFAHREN ZUR VERSORGUNG EINER ANLAGE ZUR BESCHICHTUNG VON WERKSTÜCKEN MIT FÜR DEN BESCHICHTUNGSPROZESS BENÖTIGTEN PROZESSGASEN**

(30) Priorität: 16.02.2023 DE 102023103802
(71) Anmelder: KHS GmbH, 44143 Dortmund (DE)
(72) Erfinder: Vogelsang, Andreas, 22145 Hamburg (DE); Kytzia, Sebastian, 23826 Todesfelde (DE)
(74) Vertreter: Eisenführ Speiser

(57) **Zusammenfassung**

Die Erfindung betrifft Vorrichtungen (100) und Verfahren zur Versorgung einer Anlage (10) zur Beschichtung von Werkstücken (5) mit für den Beschichtungsprozess benötigten Prozessgasen. Die Vorrichtung weist wenigstens zwei Grundgasleitungen (124, 125; 102, 104) zum getrennten Führen von wenigstens zwei Grundgasen in einer Strömungsrichtung und wenigstens ein Mischmittel (171, 172, 173) zum Zusammenführen und Mischen von wenigstens zwei der Grundgase zu einem Gasgemisch auf. Zur dosierten Zuführung der Grundgase zum Mischmittel (171, 172, 173) ist in den Grundgasleitungen (102, 104; 124, 125) in der Strömungsrichtung der zugeführten Grundgase vor dem Mischmittel (171, 172, 173) jeweils ein Massflow-Controller (MFC; 141, 142, 143; 146, 147, 148) angeordnet. Die Vorrichtung zur Bereitstellung eines ersten Grundgases weist wenigstens einen Verdampfer (112, 114) auf, der eingerichtet und ausgebildet ist zur Überführung eines flüssigen Ausgangsfluides in den gasförmigen Zustand, wobei der Verdampfer (112, 114) hierzu insbesondere Heizmittel (115) zum Erwärmen des Ausgangsfluides mindestens bis zu dessen Siedetemperatur aufweist. Die Vorrichtung ist zur Bereitstellung eines zweiten Grundgases angeschlossen an eine Zuführleitung (102, 104) für das Zuführen des zweiten Grundgases aus einer Gasquelle. Die Vorrichtung weist einen von Wänden umgebenden Warmbereich (120) auf, der auf einer Temperatur größer oder gleich der Siedetemperatur gehalten ist. Wenigstens ein MFC (141, 142, 143) ist innerhalb dieses Warmbereiches (120) angeordnet. Wenigstens ein weiterer MFC (146, 147, 148) ist außerhalb dieses Warmbereiches (120) angeordnet.

## Beschreibung

Die Erfindung betrifft eine Vorrichtung nach dem Oberbegriff von Anspruch 1, insbesondere betrifft die Erfindung Versorgungsvorrichtungen, welche Beschichtungsanlagen mit Prozessgasen versorgen, in denen Innenwände von Behältern beschichtet werden, insbesondere mittels eines PECVD-Verfahrens (plasma enhanced chemical vapor deposition), insbesondere mittels eines mikrowelleninduzierten PECVD-Verfahrens. Weiterhin betrifft die Erfindung eine Anlage zur Beschichtung von Werkstücken mit einer solchen Versorgungsvorrichtung.

Die Erfindung betrifft darüber hinaus ein Verfahren nach dem Oberbegriff von Anspruch 8, insbesondere betrifft die Erfindung Versorgungsverfahren, welche Beschichtungsanlagen mit Prozessgasen versorgen, in denen Innenwände von Behältern beschichtet werden, insbesondere mittels eines PECVD-Verfahrens, insbesondere mittels eines mikrowelleninduzierten PECVD-Verfahrens.

Bei der chemischen Gasphasenabscheidung (CVD) werden Schichten auf Werkstücken chemisch aus der Gasphase abgeschieden. Es ist bekannt, diesen Beschichtungsvorgang durch gezieltes Erzeugen eines Plasmas zu beschleunigen. Es ist auch bekannt, das Plasma durch die Verwendung von Mikrowellenstrahlung zu erzeugen.

Verfahren und Vorrichtungen zur Versorgung von Beschichtungsanlagen mit benötigten Prozessgasen sind z.B. aus der EP 1 954 851 B1 bekannt. Solche Beschichtungsanlagen und solche Versorgungseinrichtungen für die Prozessgaszuführung zu solchen Beschichtungsanlagen sind auch aus der WO 03/10120 A2 bekannt. Gasversorgungsvorrichtungen sind auch kommerziell erhältlich.

In diesem Stand der Technik ist unter anderem gezeigt, dass benötigte Prozessgase durch das Mischen von Grundgasen bereitgestellt werden. Unter anderem erfolgt z.B. ein Mischen von schon in Gasform vorliegenden Grundgasen mit Grundgasen, die erst durch Verdampfen eines Ausgangsfluides bereitgestellt werden müssen. Die Erfindung geht davon aus, dass ein erstes Grundgas bereits in Gasform vorliegt und z.B. der Versorgungsvorrichtung in dieser Gasform von außen zugeführt wird. Dieses bereits gasförmig vorliegende Grundgas könnte aber auch in einem Gasvorrat innerhalb der Vorrichtung bereitgehalten sein. Üblicher ist das Zuführen des gasförmigen Grundgases zu der Versorgungsvorrichtung, z.B. durch Anschließen der Versorgungsvorrichtung an Gasversorgungsleitungen. Ein solches schon in Gasform vorliegendes Grundgas kann z.B. Argon sein, Sauerstoff, Stickstoff oder andere aus Beschichtungsverfahren bekannte Gase, die z.B. als Trägergase verwendet werden.

Die Erfindung geht weiterhin davon aus, dass ein zweites Grundgas nicht bereits gasförmig vorliegt, sondern dass dieses Grundgas durch Verdampfen eines Ausgangsfluides innerhalb der Versorgungsvorrichtung bereitgestellt werden muss. Beispiele für ein solches Ausgangsfluid sind HMDSO (Hexamethyldisiloxan) oder HMDSN (Hexamethyldisilazan) oder andere Monomere. Die genannten Ausgangsfluide, auch als Precursor bezeichnet, werden z.B. verwendet zur Abscheidung quarzähnlicher Schichten von Siliziumdioxid. Für dieses Verdampfen ist erforderlich, dass das Ausgangsfluid erwärmt wird wenigstens bis zum Erreichen der Siedetemperatur und dadurch in den gasförmigen Aggregatzustand übergeht. Damit das entstandene Gas nicht auf seinem weiteren Weg kondensiert, ist z.B. bekannt, Leitungen, Ventile oder auch Massenflussregler (MFC), durch die das durch Verdampfen entstandene Gas geleitet wird, ebenfalls auf eine Temperatur oberhalb der Siedetemperatur zu halten. Auch Bereiche, in denen das durch Verdampfen entstandene Grundgas mit anderen Grundgasen zu einem Prozessgasgemisch zusammengeführt und dadurch gemischt wird, auch als Mischbereiche zu bezeichnen, werden in der Regel auf einer Temperatur oberhalb der Siedetemperatur gehalten. Zu dem genannten Zweck ist bekannt, dass Prozessgasversorgungsvorrichtungen einen von Wänden umgebenen Warmbereich aufweisen, der auf einer Temperatur größer oder gleich der Siedetemperatur für den Precursor gehalten ist. Der Warmbereich ließe sich zutreffend auch als Warmkammer bezeichnen. Die genannten Leitungen, Ventile oder auch MFC sowie auch die Mischbereiche, in denen die Grundgase zu den Prozessgasgemischen zusammengeführt werden, sind in diesem Warmbereich angeordnet.

Gerade im Bereich der Innenbeschichtung von Behältern, z.B. von Flaschen aus einem thermoplastischen Kunststoff, z.B. aus PET, erfolgt dieses Beschichten bevorzugt auf Rundläufern, d. h. die Plasmastationen, in denen die Behälter mit einer Innenbeschichtung versehen werden, sind auf einem umlaufenden Beschichtungsrad angeordnet. Dies ermöglicht hohe Produktionsraten. Für ein Erhöhen der Produktionsraten ist erforderlich, dass auch das Prozessgas in ausreichender Menge bereitgestellt werden kann. Ein Erhöhen der Ausstoßleistung setzt also voraus, dass die pro Zeiteinheit von der Versorgungsvorrichtung zugeführte Menge an Prozessgasen gesteigert wird.

Sehr hohe Produktionsraten lassen sich erzielen, wenn der Beschichtungsvorgang mit einem PECVD-Verfahren ausgeführt wird. Insofern wird nachfolgend primär abgestellt auf solche PECVD-Verfahren, insbesondere auf mikrowelleninduzierte PECVD-Verfahren und hier insbesondere auf solche zur Innenbeschichtung von Behältern, z.B. von Flaschen aus thermoplastischem Kunststoff, z.B. aus PET. Dies erfolgt lediglich beispielhaft, aber das nachfolgend geschilderte Problem ergibt sich für dieses gewählte Beispiel besonders dringend.

Für die Innenbeschichtung von PET-Flaschen können z.B. HMDSO und/oder HMDSN als Ausgangsfluide verwendet werden. Beide liegen üblicherweise in flüssiger Form vor und müssen zur Bereitstellung als Grundgas verdampft werden. Typischerweise findet das Verdampfen bei etwa 45 °C statt. Die verdampften Monomere werden dann in Leitungen geführt und es erfolgt z.B. eine Dosierung durch in den Leitungen vorgesehene MFC. Damit die verdampften Monomere nicht an den Leitungen oder im MFC kondensieren, werden auch diese Leitungen und das MFC auf eine Temperatur oberhalb von 45 °C gehalten, d. h. der Warmbereich weist wenigstens eine Temperatur von 45 °C auf. Bevorzugt wird diese Temperatur etwa 5°C höher gewählt, als die Siedetemperatur des flüssigen Precursors HMDSO und/oder HMDSN.

Diese erläuterte Vorgehensweise bedeutet aber auch, dass die im Warmbereich angeordneten MFC bei der Warmraumtemperatur über einen längeren Zeitraum zuverlässig arbeiten müssen. Es gibt kommerziell erhältliche MFC, die bei diesen Temperaturen zuverlässig funktionieren. Diese MFC`s sind aber in der Anschaffung deutlich teurer als sonst übliche MFC, die bei üblicher Raumtemperatur arbeiten.

Wie eingangs ausgeführt, besteht ein Bedarf, Beschichtungsanlagen mit immer größerer Ausstoßleistung bereitzustellen. Entsprechend müsste eine größere Menge an flüssigem Precursor pro Zeiteinheit verdampft werden. Dies könnte unter anderem erreicht werden, indem in den Gasversorgungsvorrichtungen der Precursor deutlich über dessen Siedepunkt aufgeheizt wird, im Falle von HMDSO oder HMDSN z.B. nicht auf etwa 45 °C, sondern z.B. auf 55 °C oder 60 °C oder sogar 65 °C. Dies würde aber auch bedeuten, dass eine entsprechende Temperatursteigerung auch für den Warmraum erforderlich ist, um weiterhin zuverlässig Kondensatbildung des aus dem flüssigen Precursor entstandenen Grundgases zu vermeiden. Im genannten Beispiel müsste also der Warmraum ebenfalls auf z.B. 55 °C oder 60 °C oder sogar 65 °C geheizt sein und bevorzugt sogar 5 °C wärmer sein als der im Verdampfer erhitzte Precursor, also sogar bis zu 70 °C Raumtemperatur aufweisen. Dies würde die Anforderungen z.B. an MFC signifikant erhöhen und auch die Kosten geeigneter MFC signifikant steigern. Denkbar wäre auch, eine zusätzliche Versorgungsvorrichtung vorzusehen und somit die Gesamtversorgung der Beschichtungsanlage mit mehr als einer Prozessgasversorgungsvorrichtung zu realisieren. Auch dies ist mit Kostennachteilen und erhöhter Anlagenkomplexität verbunden.

Bislang gibt es keine zufriedenstellende Lösung, um diesem dargestellten Problem ohne Inkaufnahme hoher Kostensteigerungen zu begegnen und dennoch die Produktionsrate von Beschichtungsanlagen künftig weiter steigern zu können.

Der Erfindung liegt daher die Aufgabe zugrunde, eine verbesserte Lösung bereitzustellen, welche die genannten Probleme adressiert. Es ist insbesondere die Aufgabe der vorliegenden Erfindung, eine Vorrichtung der einleitend genannten Art derart weiterzubilden, dass für hohe Produktionsraten von Beschichtungsanlagen eine ausreichende Prozessgasmenge bereitgestellt werden kann, ohne dass signifikante Mehrkosten z.B. bei den MFC in Kauf genommen werden müssen.

Gemäß einem ersten Aspekt der Erfindung wird die Aufgabe erfindungsgemäß gelöst durch eine Vorrichtung mit den kennzeichnenden Merkmalen von Vorrichtungsanspruch 1.

Die erfindungsgemäße Vorrichtung weist wenigstens zwei Grundgasleitungen zum getrennten Führen von wenigstens zwei Grundgasen in einer Strömungsrichtung und wenigstens ein Mischmittel zum Zusammenführen und Mischen von wenigstens zwei der Grundgase zu einem Gasgemisch auf. Das Zusammenführen von Gasen führt bereits zu einem Mischen der Gase, sodass ein solches Mischmittel bereits darin bestehen kann, zwei getrennte Leitungen zu einem gemeinsamen Kreuzungspunkt zu führen und die entstandene Mischung dann z.B. in einer gemeinsamen Leitung weiterzuführen. Für das Abscheiden einer Schicht mit gewünschten Eigenschaften und zum Erreichen einer möglichst gleich bleibenden Schichtqualität über viele Beschichtungsvorgänge hinweg erfolgt das Zuführen der Grundgase zum Mischmittel in einer dosierten Form, sodass auch das Gasgemisch eine gleichbleibende Qualität aufweist. Diese dosierte Zuführung der Grundgase wird gewährleistet, indem jeweils ein Massflow-Controller (MFC) in den Grundgasleitungen angeordnet ist und dieses in Strömungsrichtungen der zugeführten Grundgase vor dem Mischmittel angeordnet ist, sodass dem Mischmittel die Grundgase in einer gewünschten Dosierung zugeführt werden. Die Dosierung wird mittels der MFC eingestellt und die MFC können z.B. zur Veränderung oder Anpassung der Dosierung steuerbar ausgeführt sein. MFC`s sind grundsätzlich im Stand der Technik bekannt, sodass eine detaillierte Beschreibung des Aufbaus und des Funktionsprinzip solcher MFC`s nicht erforderlich ist.

Statt der genannten MFC, die als bevorzugte Ausführungsform betrachtet werden, könnten auch andere Arten von geregeltem Ventilen (z.B. Nadelventile) vorgesehen sein. Lösungen abseits von MFCs haben technische Nachteile, sodass nachfolgend, aber ohne Beschränkung der Allgemeinheit nur noch von MFC gesprochen wird, auch in der Figurenbeschreibung. Dort könnte auch allgemein ein geregeltes Ventil, z.B. ein Nadelventil genannt sein, ohne dass dadurch die Erfindung verlassen wird. MFC steht insofern also platzhaltend wird alle geregelten Ventile.

Dem Mischmittel soll wenigstens ein Grundgas zugeführt werden, das bereits in Gasform vorliegt und aus einer Gasquelle zugeführt wird. Diese Gasquelle ist in der Regel z.B. eine externe Gasquelle, an der die Versorgungsvorrichtung über eine Gasversorgungsleitung angeschlossen ist. Die Gasquelle könnte aber auch ein in der Vorrichtung angeordneter Vorratstank sein, in dem das benötigte Grundgas bereitgehalten wird. Mögliche und im Stand der Technik grundsätzlich bekannte Grundgase, die bereits gasförmig vorliegen, sind z.B. Argon, Helium, sonstige Edelgase, Sauerstoff, Stickstoff, gasförmiges Acetylen.

Dem Mischmittel soll zusätzlich wenigstens ein weiteres Grundgas zugeführt werden, welches aus einer Ausgangsflüssigkeit erzeugt wird. Dazu weist die Vorrichtung einen Verdampfer auf. Der Verdampfer ist eingerichtet und ausgebildet zur Überführung eines flüssigen Ausgangsfluides in den gasförmigen Zustand, wobei der Verdampfer hierzu insbesondere Heizmittel zum Erwärmen des Ausgangsfluides mindestens bis zu dessen Siedetemperatur aufweist. Typische, gleichwohl rein beispielhaft genannte Ausgangsflüssigkeiten, sind die Monomere HMDSN und/oder HMDSO, welche auch bereits im Stand der Technik als geeignete Precursor bekannt sind. Weitere mögliche Ausgangsflüssigkeiten für den vorliegenden Anwendungsfall sind flüssiges Acetylen oder siliziumbasierte Monomere (u.a. TMDSO, HMDS, etc.). Je nach Art der gewünschten Schicht gibt es aber auch metallorganische Flüssigkeiten, um metallische Schichten abzuscheiden, oder z.B. Diethylamin für aminogruppenhaltige Schichten. Der Verdampfer kann z.B. in seiner Temperatur geregelt sein, z.B. in der Art, dass die Ausgangsflüssigkeit auf einer bestimmten Temperatur gehalten ist, z.B. auf einer bestimmten Temperatur oberhalb der Siedetemperatur des Precursors. Denkbar ist auch, dass zusätzlich der Druck im Verdampfer gemessen und ein entsprechender Drucksensor in die Steuerung bzw. Regelung des Verdampfers eingebunden ist. Nach dem Verdampfen wird dieses weitere Grundgas über Leitungen dem Mischmittel zugeführt und auch dies erfolgt in dosierter Weise, indem in diese Zuleitung ein MFC angeordnet ist.

Es ist im Stand der Technik bekannt, in der Versorgungsvorrichtung einen von Wänden umgebenen Warmbereich vorzusehen. Alternativ könnte dieser Warmbereich als Warmkammer bezeichnet werden. In diesem Bereich bzw. in dieser Kammer wird die Temperatur der darin verlaufenden Leitungen, Ventile, MFC oder sonstiger Mittel, an denen eine Kondensation des aus dem Verdampfer kommenden Grundgases erfolgen könnte, bei oder oberhalb der Siedetemperatur des im Verdampfer verdampften Precursors gehalten. Bevorzugt ist es, diese Temperatur 5 °C oberhalb der Siedetemperatur des Precursors zu halten. Wenn mehrere Precursor verdampft werden zur Bereitstellung von mehreren Grundgasen, so könnte z.B. die höhere Siedetemperatur als Basis für die Wahl der Temperatur des Warmbereiches genommen werden. Im Stand der Technik werden unterschiedslos alle MFC in diesem Warmbereich angeordnet. Demgegenüber soll erfindungsgemäß wenigstens ein MFC außerhalb des Warmbereiches angeordnet sein. Die Erfindung schlägt also vor, die mindestens zwei MFC bezüglich ihrer Anordnung aufzuteilen und wenigstens einen MFC im Warmbereich und wenigstens einen MFC außerhalb des Warmbereiches anzuordnen. Bevorzugt sollte der im Warmbereich angeordnete MFC derjenige sein, der in der Leitung angeordnet ist, in der aus einem flüssigen Ausgangsfluid entstandenes Grundgas geführt ist. Das mindestens eine MFC, das außerhalb des Warmbereiches angeordnet ist, ist bevorzugt in einer Leitung angeordnet, in der Grundgas aus einer Gasquelle geführt ist. Soweit die Versorgungsvorrichtung weitere Grundgasleitungen aufweist, in denen ein weiteres Grundgas aus einer Gasquelle geführt ist, so werden bevorzugt auch die diesen weiteren Grundgasleitungen zugeordneten MFC außerhalb des Warmbereiches angeordnet. Soweit die Versorgungsvorrichtung weitere Grundgasleitungen aufweist, in denen weitere, aus einem flüssigen Ausgangsfluid entstandene Grundgase geführt sind, so werden bevorzugt die zugeordneten MFC jeweils innerhalb des Warmbereiches angeordnet. Die Erfindung schlägt also die Anordnung im Warmbereich nur für die MFC vor, die Leitungen zugeordnet sind, in denen aus Precursern durch Verdampfen entstandene Grundgase geführt sind. Nicht nur die MFC, auch die Leitungen, die das im Verdampfer entstehende Grundgas führen, und auch die Mischmittel, in denen dieses Grundgas mit einem anderen Grundgas gemischt wird, sollten ebenfalls im Warmbereich angeordnet sein.

Auf die oben geschilderte Weise wird bereits ein Teil der MFC nicht mehr im Warmbereich angeordnet und somit müssen jedenfalls für diese nicht im Warmbereich angeordneten MFC keine erhöhten Anforderungen gestellt werden. Es können bei normaler Raumtemperatur funktionsfähige und somit kostengünstigere MFC gewählt werden.

Eine weitere Aufgabe der vorliegenden Erfindung ist es insbesondere, ein Verfahren der einleitend genannten Art derart fortzubilden, dass für hohe Produktionsraten von Beschichtungsanlagen eine ausreichende Prozessgasmenge bereitgestellt wird, ohne dass signifikante Mehrkosten z.B. bei den MFC in Kauf genommen werden müssen.

Gemäß einem weiteren Aspekt der Erfindung wird diese genannte Aufgabe erfindungsgemäß gelöst durch ein Verfahren mit den kennzeichnenden Merkmalen von Verfahrensanspruch 8, die spiegelbildlich sind zu dem kennzeichnenden Merkmal von Vorrichtungsanspruch 1.

Vorteilhafte Ausgestaltungen der Vorrichtung und des Verfahrens sind in den jeweiligen Unteransprüchen angegeben. Die nachfolgend diskutierten bevorzugten Ausführungsformen des Verfahrens finden sich spiegelbildlich auch in der Vorrichtung wieder. Umgekehrt finden sich die nachfolgend diskutierten bevorzugten Ausführungsformen der Vorrichtung spiegelbildlich auch in dem Verfahren wieder. Die jeweils angegebenen Vorteile des Verfahrens bzw. der Vorrichtung sind spiegelbildlich auch Vorteile der Vorrichtung bzw. des Verfahrens. Das erfindungsgemäße Verfahren kann auf den erfindungsgemäßen Vorrichtungen ausgeführt werden.

Alle vorgestellten Vorrichtungen und Verfahren finden insbesondere Verwendung bei der Beschichtung von Innenwänden von Behältern, insbesondere mittels eines PECVD-Verfahrens, insbesondere mittels eines mikrowelleninduzierten PECVD-Verfahrens. Solche Beschichtungen werden insbesondere bei aus einem thermoplastischen Kunststoff, z.B. PET, bestehenden Flaschen eingesetzt, die z.B. aus Vorformlingen hergestellt werden, um durch das Beschichten die Barriereeigenschaften zu verbessern. Diese Barriereeigenschaften betreffen z.B. einerseits das Eindringen von Sauerstoff von außen in den Behälter und in das darin abgefüllte Füllgut, und andererseits z.B. das Austreten von Kohlendioxid, soweit z.B. ein karbonisiertes Füllgut im Behälter abgefüllt wird.

Die MFC weisen in aller Regel eine Steuerelektronik auf, um die gewünschte Dosierung des jeweiligen Grundgases leisten zu können. Mit Vorteil wird vorgeschlagen, die Steuerelektronik des wenigstens einen im Warmbereich angeordneten MFC außerhalb des Warmbereiches anzuordnen. Die Anordnung des MFC und die Anordnung derzugehörigen Steuerelektronik werden also räumlich getrennt. Es besteht zwischen diesen getrennten Elementen eine Kommunikationsverbindung. Gerade die Elektronik ist diejenige Komponente des MFC, die bezüglich der Temperatur kritisch ist. Aufgrund dieser vorgeschlagenen räumlichen Trennung muss nicht auf eine besondere Temperaturstabilität des MFC geachtet werden, sondern dessen temperaturempfindlichen Bestandteile, namentlich die Steuerelektronik, werden außerhalb des Warmbereiches angeordnet, sodass insgesamt wieder ein kostengünstigeres MFC verwendet werden kann. Es sind im Stand der Technik MFC bekannt, bei denen die Steuerelektronik entfernt vom MFC angeordnet werden kann. Diese sind kommerziell verfügbar.

Soweit mehrere Grundgase durch Verdampfen flüssiger Precursor bereitgestellt werden, ist es vorteilhaft, für alle diese Grundgase wie oben beschrieben vorzugehen und also alle zugeordneten MFC im Warmbereich anzuordnen und bevorzugt die jeweilige Steuerelektronik aller dieser MFC außerhalb des Warmbereiches anzuordnen. Auf diese Weise lässt sich insgesamt eine kostengünstige Lösung realisieren und der Rückgriff auf kostspielige MFC vermeiden.

Entsprechend ist mit Vorteil mit MFC zu verfahren, wenn weitere Grundgasleitungen für das Zuführen eines weiteren Grundgases aus einer Gasquelle vorgesehen sind. Diese wären bevorzugt alle außerhalb des Warmbereiches anzuordnen. Für ein getrenntes Anordnen der Steuerelektronik dieser ohnehin außerhalb des Warmbereiches angeordneten MFC besteht keine Notwendigkeit. Gleichwohl könnten auch die Steuerelektroniken dieser MFC beabstandet von den MFC angeordnet werden, und es könnten z.B. alle Steuerelektroniken aller MFC in einem Steuerbereich angeordnet sein, derz.B. bezüglich Umgebungstemperatur und Umgebungsbedingungen klimatisiert ist und/oder der in räumlicher Nähe zu der Steuereinrichtung der Gasversorgungsvorrichtung und/oder in räumlicher Nähe zu der Steuereinrichtung der mit Prozessgas versorgten Beschichtungsanlage angeordnet ist.

Wie eingangs ausgeführt, ist die Temperatur im Warmbereich mit Vorteil im Bereich der oder oberhalb der Siedetemperatur des im Verdampfer verdampften Precursors gewählt. Für ein noch zuverlässigeres Vermeiden einer Kondensation ist die Temperatur im Warmbereich wenigstens 5 °C über der Siedetemperatur gehalten. Soweit Grundgase aus mehr als einem flüssigen Precursor durch Verdampfen erzeugt werden, wäre für die Temperatur des Warmbereiches bevorzugt die höhere der Siedetemperaturen bestimmend, d. h. die Temperatur im Warmbereich wäre im Bereich der oder oberhalb der höheren Siedetemperatur zu wählen oder wenigstens 5 °C höher. Grundsätzlich denkbar ist auch, zwei Warmbereiche vorzusehen, und in dem einen Warmbereich eine andere Temperatur einzustellen als im anderen Warmbereich, jeweils entsprechend der Siedetemperatur des Precursors, dessen zugeordneter MFC in diesem Warmbereich angeordnet ist, wobei im Falle einer Mischung von zwei aus einem flüssigen Precursor entstandenen Grundgasen das entsprechende Mischmittel im Warmbereich angeordnet ist mit der höheren Temperatur. Im Falle von mehr als zwei aus flüssigen Precursern bereitgestellten Grundgasen gilt Analoges.

Eine Steigerung der zur Verfügung stellbaren Gasmenge gelingt dadurch, dass der Verdampfer ausgebildet ist, das Ausgangsfluid mindestens um 10 °C, bevorzugt mindestens um 15 °C und weiter bevorzugt mindestens um 20 °C oberhalb dessen Siedetemperatur aufzuheizen, wobei die Temperatur im Warmbereich dieser Aufheiztemperatur entspricht, und besonders bevorzugt wenigstens 5 °C oberhalb dieser Aufheiztemperatur gehalten ist. Da wenigstens einige wärmekritische MFC und mit Vorteil insbesondere die wärmekritischen Steuerelektroniken der MFC nicht im Warmbereich angeordnet sind, lässt sich eine solche Temperaturerhöhung realisieren, ohne dass damit automatisch Kostensteigerungen bei den zu verwendenden MFC in Kauf genommen werden müssen. Soweit mehrere Grundgase aus einem Ausgangsfluid verdampft werden, gilt das Vorgenannte bevorzugt für jeden der dann mehreren Verdampfer. Auch bei dieser Ausführungsvariante würde sich die Temperatur im Warmbereich bevorzugt an der höheren der Aufheiztemperaturen orientieren, wobei grundsätzlich auch die Möglichkeit besteht, mehr als einen Warmbereich vorzusehen, so wie im vorhergehenden Absatz erläutert.

Eine bevorzugte Anwendung findet eine erfindungsgemäße Vorrichtung in einer Anlage zur Beschichtung von Werkstücken, insbesondere zur Beschichtung von Innenwänden von Behältern, insbesondere mittels eines PECVD-Verfahrens, insbesondere mittels eines mikrowelleninduzierten PECVD-Verfahrens.

Zu den Vorteilen, Ausführungsvarianten und Ausführungsdetails der verschiedenen Aspekte der hier beschriebenen Lösungen und ihrer jeweiligen möglichen Fortbildungen wird auch auf die Beschreibung zu den entsprechenden Merkmalen, Details und Vorteilen der jeweils anderen Aspekte und ihrer Fortbildungen verwiesen.

Nachfolgend wird die Erfindung anhand von bevorzugten Ausführungsbeispielen und anhand der beiliegenden Figuren näher erläutert. Die Zeichnungen sind nicht unbedingt maßstabsgetreu. In den Figuren sind gleiche oder im Wesentlichen funktionsgleiche bzw. -ähnliche Elemente mit den gleichen Bezugszeichen bezeichnet. Es zeigen:
- Fig. 1: eine schematische Aufsicht auf eine Beschichtungsanlage, wie sie im Grundaufbau und grundsätzlich im Stand der Technik bekannt ist;
- Fig. 2: eine perspektivische Ansicht auf ein erstes Beispiel für eine vereinzelte Besch ichtu ngsstation;
- Fig. 3: eine Schnittansicht durch ein zweites Beispiel für eine vereinzelte Plasmastation mit Doppelkammer;
- Fig. 4: eine perspektivische Ansicht auf eine Gasversorgungsvorrichtung für eine Beschichtungsvorrichtung;
- Fig. 5: eine Prinzipskizze zu den Vorgängen in einer Gasversorgungsvorrichtung am Beispiel von zwei Trägergasen und zwei Grundgasen, die durch Verdampfen von Monomeren bereitgestellt werden;

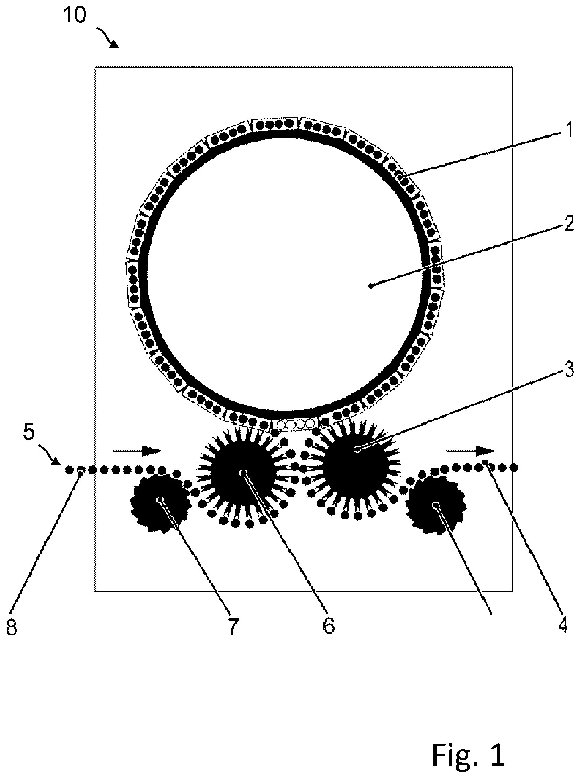

Aus der Darstellung in Fig. 1 ist eine Beschichtungsanlage, genauer gesagt eine PECVD-Anlage 10 zu erkennen, die mit einem rotierenden Plasmarad 2 versehen ist. Entlang eines Umfanges des Plasmarades 2 sind umfangsbeabstandet eine Mehrzahl von Plasmastationen 1 angeordnet. Die Plasmastationen 1 sind mit später noch gezeigten Kavitäten bzw. Plasmakammern 17 zur Aufnahme von zu behandelnden Werkstücken 5 versehen. Beispielhaft ist gezeigt, dass jede Plasmastation vier Behandlungsplätze aufweist. Diese PCVD-Anlage 10 steht rein exemplarisch für alle Beschichtungsanlagen, die unter Zuführung von Prozessgasen Beschichtungsprozesse ausführen. Weiterhin werden nachfolgend die Werkstücke lediglich beispielhaft von Behältern gebildet.

Die zu behandelnden Behälter 5 werden dem Plasmarad 2 im Bereich einer Eingabe 8 zugeführt und über ein Vereinzelungsrad 7 an ein Übergaberad 6 weitergeleitet, das mit Tragarmen ausgestattet ist, die z.B. positionierbar ausgeführt sein können. Die Tragarme können z.B. relativ zu einem Sockel des Übergaberades 6 verschwenkbar angeordnet sein, so daß eine Abstandsveränderung der Behälter 5 relativ zueinander durchgeführt werden kann. Hierdurch erfolgt eine Übergabe der Behälter 5 vom Übergaberad 6 an das Plasmarad 2. Nach einer Durchführung der Behandlung während des Umlaufes auf dem Plasmarad 2 werden die behandelten Behälter 5 von einem Ausgaberad 3 aus dem Bereich des Plasmarades 2 entfernt und in den Bereich einer Ausgabestrecke 4 überführt.

Es sind im Stand der Technik die beiden Möglichkeiten bekannt, die z.B. als Behälter ausgebildeten Werkstücke 5 mit Mündungsbereich nach oben oder nach unten weisend zu beschichten. Da der Transport der Behälter 5 einfacher ist, wenn der Mündungsbereich nach oben weist, könnte z.B. die Zuführung der Behälter 5 im Bereich der Eingabe 8 mit Mündungsbereich nach oben weisend erfolgen und z.B. auf dem Übergaberad 6 der Behälter 5 gewendet werden in eine Positionierung mit Mündungsbereich nach unten. Arbeitsräder mit einer solchen Wendefunktion sind im Stand der Technik bekannt. In dieser Positionierung würde die Übergabe der Behälter 5 auf das Plasmarad 2 erfolgen und auch die Entnahme vom Plasmarad 2 nach erfolgter Behandlung. Das Ausgaberad 3 könnte dann erneut ein Wenden des Behälters 5 vornehmen und der Behälter 5 anschließend mit einer Positionierung mit Mündung nach oben der Ausgabestrecke 4 zugeführt werden. Ohne Beschränkung der Allgemeinheit wird in nachfolgenden Abbildungen eine Positionierung des Behälters 5 mit Mündungsbereich nach unten weisend gezeigt. Möglich ist natürlich auch, dass die Behandlung auf dem Plasmarad mit Mündungsbereich nach oben weisenden erfolgt und kein Wendevorgang vor und nach dem Plasmarad ausgeführt wird.

In nicht dargestellter Weise, weil im Stand der Technik hinreichend bekannt, werden den mit dem Plasmarad 2 umlaufenden Plasmastationen 1 die für den Beschichtungsprozess notwendigen Prozessgase zugeführt. Die Zuführung erfolgt in der Regel in einem Zentrum des Plasmarades 2 und über einen dort angeordneten Drehverteiler, über den die Plasmastationen 1 auch mit weiteren Betriebsmitteln sowie Energie versorgt werden. Zur Betriebsmittelverteilung werden insbesondere Ringleitungen eingesetzt. Die auf das Plasmarad 2 übergebenen Prozessgase liegen bei der Übergabe in der erforderlichen Zusammensetzung vor und werden von einer außerhalb des Plasmarades 2 angeordneten Gasversorgungsvorrichtung bereitgestellt, die später beschrieben wird.

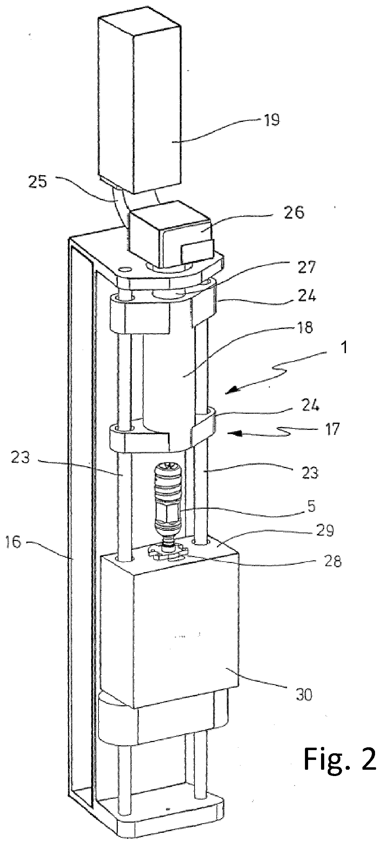

In Fig. 2 ist zur Erläuterung eines möglichen grundsätzlichen Aufbaus einer Plasmastation 1 in perspektivischer Darstellung eine Station mit einem Einzelbehandlungsplatz gezeigt. Ein Stationsrahmen 16 ist mit Führungsstangen 23 versehen, auf denen ein Schlitten 24 zur Halterung der zylinderförmigen Kammerwandung 18 geführt ist. Fig. 2 zeigt den Schlitten 24 mit Kammerwandung 18 in einem angehobenen Zustand, so daß das auf dem Kopf stehende Werkstück in Form eines Behälters 5 freigegeben ist.

Im oberen Bereich der Plasmastation 1 ist ein Mikrowellengenerator 19 angeordnet. Der Mikrowellengenerator 19 ist über eine Umlenkung 25 und einen Adapter 26 an einen Kopplungskanal 27 angeschlossen, der in die Plasmakammer 17 einmündet. Der Adapter 26 hat die Funktion eines Übergangselementes. Die Umlenkung 25 ist als ein Hohlleiter ausgebildet. Der Behälter 5 wird im Bereich eines Dichtelementes 28 positioniert, das im Bereich eines Kammerbodens 29 angeordnet ist. Der Kammerboden 29 ist als Teil eines Kammersockels 30 ausgebildet.

Zum Schließen der Plasmakammer 17 kann der Schlitten 24 mit der zylinderförmigen Kammerwandung 18 entlang der Schienen 23 abgesenkt werden, bis die Kammerwandung 18 gegen den Kammerboden 29 gefahren ist. In diesem geschlossenen Positionierzustand kann die Plasmabeschichtung des dann in der geschlossenen Kavität 17 eingeschlossenen Behälters 5 durchgeführt werden. Im geschlossenen Positionierzustand erfolgt auch das Einstellen des in der Kammer 17 und des im Behälter 5 erforderlichen Unterdruckes, um ein Plasma zu erzeugen und mikrowelleninduziert die Plasmabeschichtung vorzunehmen.

In der in Fig. 2 gezeigten angehobenen Positionierung der Kammerwandung 18 ist es ohne Probleme möglich, den behandelten Behälter 5 aus dem Bereich der Plasmastation 1 zu entfernen und einen neuen zu behandelnden Behälter 5 einzusetzen, z.B. mittels der in Figur 1 gezeigten Räder 6 und 3.

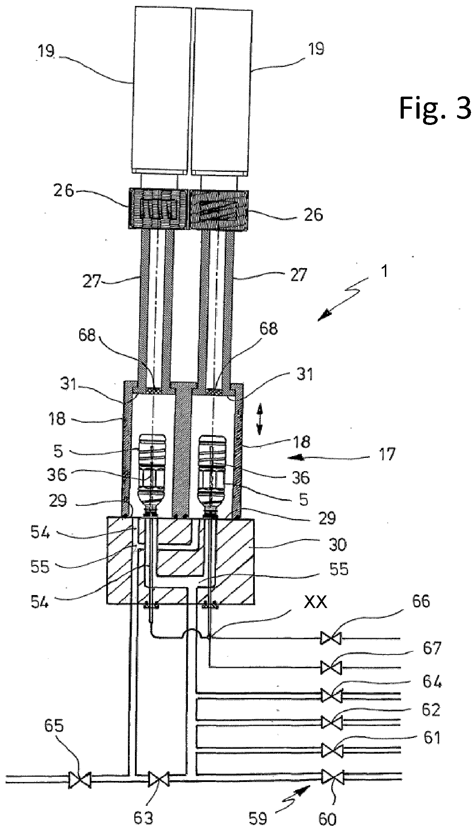

Fig. 3 zeigt ein alternatives Beispiel für eine Plasmastation 1 mit zwei Plasmakammern 17 zur gleichzeitigen Plasmabehandlung von zwei Behältern 5. Jede der Plasmakammern 17 ist über einen Kopplungskanal 27 sowie einen Adapter 26 und eine Umlenkung 25 an jeweils einen Mikrowellengenerator 19 angeschlossen. Grundsätzlich ist es ebenfalls denkbar, für zwei oder mehr Plasmakammern 17 einen gemeinsamen Mikrowellengenerator 19 zu verwenden und über eine nicht dargestellte Verzweigung eine Aufteilung der generierten Mikrowellenstrahlung vorzunehmen, um eine gleichmäßige Zündung des Plasmas in jeder der Plasmakammern 17 zu gewährleisten.

In die Plasmakammern 17 münden Kopplungskanäle 54 ein, die jeweils an eine Verzweigung 55 zur Aufteilung einer Menge eines zugeführten Betriebsmittels in zwei Teilmengen angeschlossen sind. Bei einer Verwendung von mehr als zwei Plasmakammern 17 wird die Verzweigung 55 entweder mit einer entsprechenden Anzahl von Ausgängen versehen, oder es werden kaskadiert mehrere Teilverzweigungen hintereinander angeordnet. Über diese Kanäle 54, 55 kann z.B. Unterdruck zugeführt werden.

Zusätzlich eingezeichnet ist eine Gaslanze 36, die in vertikaler Richtung in den Behälter 5 hineingefahren und herausgeführt werden kann, z.B. in nicht dargestellter Weise durch Anordnung an einem Lanzenschlitten, der in vertikaler Richtung geführt und z.B. kurvengesteuert eine Vertikalbewegung ausführen kann. In der dargestellten Positionierung ist die Plasmakammer 17 geschlossen und die Lanze 36 innerhalb des Behälters 5 angeordnet für das Austragen der Prozessgase in den Innenraum des Behälters 5.

Im Bereich des Kammersockels 30 erfolgt über die schon angesprochenen Kanäle 54, 55 die Beaufschlagung der Plasmakammern 17 und der Behälter 5 mit Unterdruck. Prozessgase werden über eine Leitung 66 der Gaslanze 36 zugeführt und in das Behälterinnere geleitet. Die Zuführung all dieser Betriebsmittel erfolgt ventilgesteuert. Die Leitung 66 steht in Verbindung mit einer Gasversorgungsvorrichtung und führt die von dieser Gasversorgungsvorrichtung bereitgestellten Prozessgase zur Gaslanze 36.

Fig. 3 zeigt in einer stark schematisierten Darstellung sowie mit zusätzlicher Darstellung von Ventilen 59 die Steuerung einer Betriebsmittelzufuhr. Beim dargestellten Ausführungsbeispiel sind aufgrund der schaltungstechnischen Anordnung der Kopplungskanäle 54 drei Verzweigungen 55 verwendet. Zu erkennen sind ebenfalls Quarzglasfenster 68 zur Abdichtung der Innenräume der Plasmakammern 17 relativ zu den Innenräumen der Kopplungskanäle 27 bei gleichzeitiger Durchtrittsmöglichkeit für die Mikrowellenstrahlung.

Gemäß der gezeigten, rein beispielhaften Ausführungsform werden ein Primärvakuumventil 60 zur Zuführung einer ersten Unterdruckstufe sowie ein Sekundärvakuumventil 61 zur Zuführung eines gegenüber der ersten Unterdruckstufe niedrigeren Unterdruckes verwendet. Das Hinzutreten weiterer Unterdruckstufen ist möglich. Zur Aufrechterhaltung des Vakuums synchron zur Zuführung des Prozessgases ist darüber hinaus ein Prozessvakuumventil 62 angeordnet. Das Prozessvakuumventil 62 vermeidet einen Übertritt von abgesaugtem Prozessgas in die Versorgungskreise für das Primärvakuum und das Sekundärvakuum.

Zur Unterstützung einer wahlweisen oder gemeinsamen Zuführung von Unterdruck zum Innenraum des Behälters 5 und/oder in den weiteren Innenraum der Plasmakammer 17 ist ein Kammervakuumventil 63 verwendet, das eine entsprechende Absperrfunktion durchführt. Insbesondere ist daran gedacht, das jeweilige Versorgungsvakuum über die Ventile 60, 61, 62 jeweils unmittelbar dem Innenraum des Behälters 5 zuzuführen und über das Kammervakuumventil 63 gesteuert eine bedarfsabhängige Zuschaltung des weiteren Innenraumes der Plasmakammer 17 vorzunehmen.

Für eine vorgebbare und voneinander unabhängige Entlüftung sowohl des Innenraumes des Behälters 5 als auch des weiteren Innenraumes der Plasmakammer 17 wird ein Behälterentlüftungsventil 64 sowie ein Kammerentlüftungsventil 65 verwendet. Für eine Zuführung unterschiedlicher Prozessgaszusammensetzungen wird ein Primärprozessgasventil 66 sowie ein Sekundärprozessgasventil 67 verwendet. Denkbar ist auch das Zuführen weiterer Prozessgasmischungen, sodass weitere Leitungen und weitere Ventile hinzutreten könnten. Die Bereitstellung der Prozessgasmischungen erfolgt durch eine Gasversorgungsvorrichtung.

Ein typischer Behandlungsvorgang wird z.B. derart durchgeführt, dass zunächst der Behälter 5 wie zu Figur 1 erläutert zum Plasmarad 2 transportiert wird und das Einsetzen des Behälters 5 in die Plasmastation 1 in einem hochgeschobenen Zustand der hülsenartigen Kammerwandung 18 erfolgt. Nach einem Abschluss des Einsetzvorganges wird die Kammerwandung 18 in ihre abgedichtete Positionierung abgesenkt und zunächst gleichzeitig eine Evakuierung sowohl der Kavität 17 als auch eines Innenraumes des Behälters 5 durchgeführt, ggf. erfolgt zunächst auch nur eine Vorevakuierung der Kavität 17, bevor auch die Evakuierung des Innenraums des Behälters 5 zugeschaltet wird.

Nach einer ausreichenden Evakuierung des Innenraumes der Kavität 17, oder aber auch schon zuvor, wird die Lanze 36 in den Innenraum des Behälters 5 eingefahren und eine Abschottung des Innenraumes des Behälters 5 gegenüber dem Innenraum der Kavität 17 durchgeführt. Ebenfalls ist es möglich, die Lanze 36 bereits synchron zur beginnenden Evakuierung des Innenraumes der Kavität 17 in den Behälter 5 hineinzuverfahren. Der Druck im Innenraum des Behälters 5 wird anschließend noch weiter abgesenkt. Darüber hinaus ist auch daran gedacht, die Positionierbewegung der Lanze 36 wenigstens teilweise bereits parallel zur Positionierung der Kammerwandung 18 durchzuführen. Nach Erreichen eines ausreichend tiefen Unterdruckes wird Prozessgas in den Innenraum des Behälters 5 eingeleitet und mit Hilfe des Mikrowellengenerators 19 das Plasma gezündet. Insbesondere ist daran gedacht, mit Hilfe des Plasmas sowohl einen Haftvermittler auf eine innere Oberfläche des Behälters 5 als auch die eigentliche Barriereschicht aus Siliziumoxiden abzuscheiden. Eine zusätzliche dritte Schicht, zum Beispiel eine Schutzschicht, könnte ebenfalls mit Hilfe des Plasmas abgeschieden werden, z.B. ebenfalls aus Siliziumoxiden.

Nach einem Abschluss des Beschichtungsvorganges wird die Lanze 36 wieder aus dem Innenraum des Behälters 5 entfernt und die Plasmakammer 17 sowie der Innenraum des Behälters 5 werden belüftet. Denkbar ist auch, erst zu belüften und anschließend die Lanze herauszufahren. Nach Erreichen des Umgebungsdruckes innerhalb der Kavität 17 wird die Kammerwandung 18 wieder angehoben, um eine Entnahme des beschichteten Behälters 5 sowie eine Eingabe eines neuen zu beschichtenden Behälters 5 durchzuführen. Das geschilderte Beschichtungsverfahren läuft ab, während der Behälter 5 in der Plasmastation 1 auf dem Plasmarad 2 umläuft.

Eine Positionierung der Kammerwandung 18 und/oder der Lanze 36 kann unter Verwendung unterschiedlicher Antriebsaggregate erfolgen. Grundsätzlich ist die Verwendung pneumatischer Antriebe und/oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades 2 eine Kurvensteuerung zu realisieren. Die Kurvensteuerung kann beispielsweise derart ausgeführt sein, dass entlang eines Umfanges des Plasmarades 2 Steuerkurven angeordnet sind, entlang derer Kurvenrollen geführt werden. Die Kurvenrollen sind mit den jeweils zu positionierenden Bauelementen gekoppelt.

Die Betätigung der Ventile 59 erfolgt vorzugsweise über eine programmierbare elektronische Steuerung. Zunächst wird nach einem Schließen der Plasmakammer 17 das Primärvakuumventil 60 geöffnet und der Innenraum des Behälters 5 und der Innenraum der Plasmakammer 17 gleichzeitig oder teilweise zeitlich versetzt evakuiert. Hierbei wird ein Druckniveau z.B. im Bereich von 20 mbar bis 50 mbar erreicht. Nach einem Schließen des Primärvakuumventils 60 erfolgt ein Öffnen des Sekundärvakuumventils 61 und der Innenraum des Behälters 5 und der Innenraum der Plasmakammer 17 werden zunächst gleichzeitig an eine Unterdruckquelle mit einem niedrigeren Druckniveau angeschlossen. Nach einer ausreichenden Evakuierung des den Behälter 5 umgebenden Innenraumes der Plasmakammer 17 schließt das Kammervakuumventil 63 und lediglich der Innenraum des Werkstückes 5 wird weiter evakuiert. Hierbei wird z.B. ein Druckniveau von etwa 0,1 mbar erreicht.

Nach einem Schließen des Kammervakuumventils 63 und einer in der Regel bereits zuvor erfolgten Positionierung der Lanze 36 innerhalb des Innenraumes des Behälters 5 öffnet das Primärprozessgasventil 66 und ein Prozessgas einer ersten Zusammensetzung wird zugeführt. Nach einer ausreichenden Prozessgaszuführung zündet der Mikrowellengenerator 19 das Plasma im Innenraum des Behälters 5. Zu einem vorgebbaren Zeitpunkt schließt das Primärprozessgasventil 66 und das Sekundärprozessgasventil 67 öffnet zur Zuführung eines Prozessgases einer zweiten Zusammensetzung. Zumindest zeitweise parallel zum Öffnen der Prozessgasventile 66, 67 öffnet auch das Prozessvakuumventil 62, um einen ausreichend niedrigen Unterdruck im Innenraum des Behälters 5 aufrecht zu erhalten. Hierbei erweist sich ein Druckniveau von z.B. etwa 0,3 mbar als zweckmäßig

Nach einem Abschluss der Plasmabeschichtung öffnet zunächst das Behälterentlüftungsventil 64 und schließt den Innenraum des Behälters 5 an einen Umgebungsdruck an. Mit einer vorgebbaren zeitlichen Verzögerung nach einem Öffnen des Behälterentlüftungsventils 64 öffnet auch das Kammerentlüftungsventil 65, um den Innenraum der Plasmakammer 17 wieder vollständig auf den Umgebungsdruck anzuheben. Nach einem zumindest annäherungsweisen Erreichen des Umgebungsdruckes innerhalb der Plasmakammer 17 kann die Plasmakammer 17 öffnen und der beschichtete Behälter 5 wird entnommen und durch einen neuen zu beschichtenden Behälter 5 ersetzt.

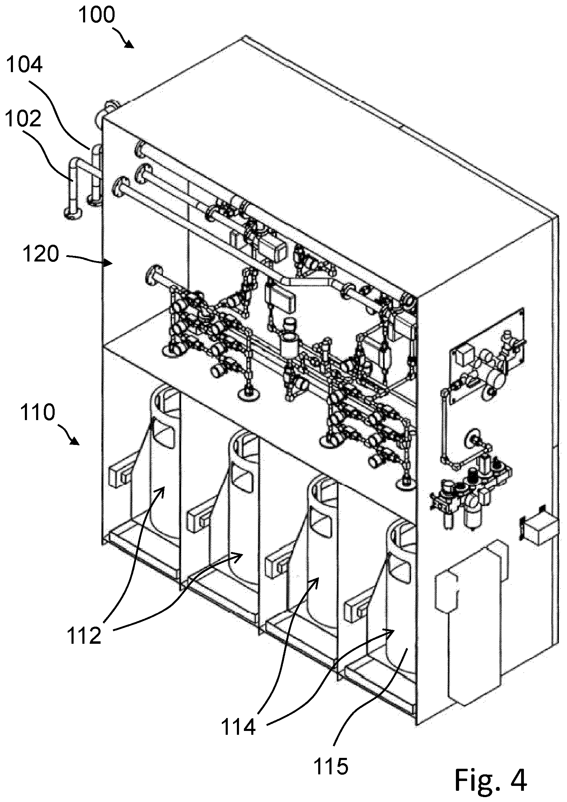

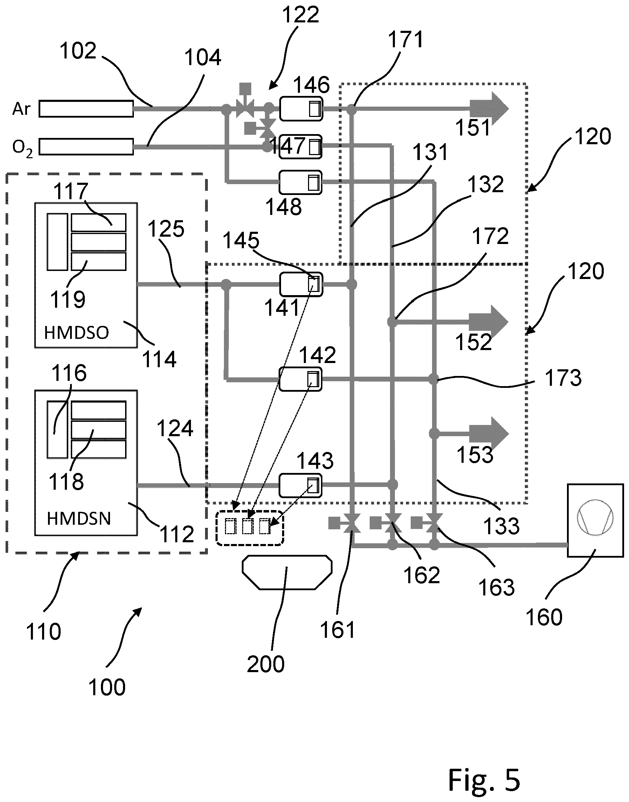

Die Bereitstellung der Prozessgase für eine beispielhaft wie oben beschriebene Beschichtungsanlage und für beispielhaft wie oben beschrieben ablaufende Beschichtungsprozesse übernimmt eine nachfolgend zu beschreibende Gasversorgungsvorrichtung 100. Figur 4 zeigt ein beispielhaftes Aussehen und einen beispielhaften Aufbau einer solchen Gasversorgungsvorrichtung 100. Figur 5 zeigt in einer Prinzipskizze, welche Vorgänge in einer solchen Gasversorgungsvorrichtung 100 ablaufen und wie eine Anordnung hierfür eingesetzter Leitungen und Dosiereinrichtungen mit Vorteil erfolgt.

Die in Figur 4 dargestellte Gasversorgungsvorrichtung 100 ist ausgeführt in Form eines Schrankes mit Seiten- und Rückwänden und mit Schranktüren im Frontbereich, die nicht gezeigt sind, um einen Blick ins Vorrichtungsinnere zu erlauben. Diese Wände begrenzen also Kammern bzw. Teilkammern der Gasversorgungsvorrichtung 100. In diesen Kammern verlaufen Leitungen und sind Einrichtungen der Gasversorgungsvorrichtung angeordnet, z.B. Einrichtungen, um Grundgase zu führen, um das Strömen der Gase zu beherrschen, um Grundgase zu dosieren, um Grundgase miteinander zu mischen und/oder um Grundgase aus Precursor-Flüssigkeiten zu erzeugen.

Der Gasversorgungsschrank 100 ist im dargestellten Beispiel in vertikaler Richtung unterteilt in einen unteren Schrankbereich 110 und einen oberen Schrankbereich 120. Im unteren Schrankbereich 110 sind im dargestellten Ausführungsbeispiel vier mit einer PrecursorFlüssigkeit gefüllte Fässer 112, 114 angeordnet, welche im gezeigten Beispiel durch Vertikalwände voneinander getrennt sind. Die beiden auf der linken Seite der Darstellung gezeigten Fässer 112 sollen z.B. HMDSN enthalten, und die beiden auf der rechten Seite der Darstellung gezeigten Fässer 114 sollen HMDSO enthalten. Alle Fässer sind in der gleichen Weise jeweils von einer Heizmanschette 115 umgeben und eine Temperatursteuerung 116 regelt die Heizleistung der jeweiligen Heizmanschetten 115 so, dass das in den Fässern 112, 114 aufgenommene Precursorfluid in den gasförmigen Zustand überführt wird. Es gelten die Ausführungen in der allgemeinen Beschreibung über vorteilhafte Temperaturen, die von diesen Manschetten 115 zusammen mit der Temperatursteuerung 116 eingestellt werden.

In dem Schrankbereich 120 vertikal oberhalb des Schrankbereiches 110 mit den Fässern 112, 114 sind diverse Leitungen, Armaturen, Ventile und Dosiermittel angeordnet, um die durch Verdampfen der Precursor bereitgestellten Grundgase zu leiten, zu dosieren und zu mischen, z.B. mit weiteren Grundgasen, die über Zuführleitungen 102, 104 seitlich links von der Gasversorgungsvorrichtung 100 in die obere Teilkammer 120 hineingeführt werden. Bei diesen schon gasförmig vorliegenden weiteren Grundgasen handelt es sich z.B. um Sauerstoff und Argon. Aus diesen bereits gasförmig der Gasversorgungsvorrichtung 100 zugeführten Grundgasen Sauerstoff und Argon sowie aus den durch Verdampfen von HMDSN und HMDSO entstehenden Grundgasen lassen sich Gasmischungen bereitstellen, um in der zuvor beschriebenen Beschichtungsanlage 10 auf der Innenwand eines Behälters 5 zeitlich nacheinander mehrere Schichten abzuscheiden, z.B. zunächst eine Haftvermittlerschicht, dann eine Barriereschicht und schließlich eine Schutzschicht. Andere Schichtaufbauten und andere Anzahlen von Schichten sind möglich. Die Teilkammer 120 mit den Leitungen, Armaturen, Ventilen und Dosiermitteln kann z.B. insgesamt als Warmbereich bzw. Warmkammer ausgeführt sein, so wie in der allgemeinen Beschreibung erläutert. Bevorzugt werden aber bestimmte Elemente außerhalb eines solchen Warmbereiches angeordnet, wie dies nachfolgend anhand der Prinzipskizze in Figur 5 verdeutlicht werden soll.

In Übereinstimmung mit dem Beispiel in Figur 4 werden über Zuführleitungen 102, 104 die Gase Argon und Sauerstoff in gasförmiger Form der Gasversorgungsvorrichtung 100 zugeführt. Diese Gase dienen z.B. als Trägergase, Sauerstoff nimmt aber auch am Abscheieprozess teil. Die flüssigen Precursor HMDSO HMDSN sind in jeweiligen Vorratsbehältern 112, 114 aufgenommen. Diese Vorratsbehälter 112, 114 sind ausgestattet z.B. mit einem Temperatursensor 117 und/oder einem Drucksensor 118 und/oder einem Füllstandssensor 119. Weiterhin weist dieser Vorratsbehälter 112, 114 eine Steuerungseinrichtung 116 auf, um die im Behälter 112, 114 enthaltene Flüssigkeit auf eine gewünschte Temperatur zu erhitzen. Beide genannten Beispiele für eine Precursorflüssigkeit weisen eine Siedetemperatur von 45 °C auf und die Erwärmung erfolgt bis mindestens auf diese Siedetemperatur, bevorzugt auf eine Temperatur oberhalb dieser Siedetemperatur. Es wird zu vorteilhaften Temperaturen auf die allgemeine Beschreibung verwiesen.

Aus Gründen der Übersichtlichkeit sind in Figur 5 nur wenige schaltbare Ventile 122 dargestellt. Es versteht sich das weitere Ventile 122 vorgesehen sein können, um den Gasstrom in den diversen Gasleitungen zu beherrschen.

Die genannten Vorratsbehälter 112, 114 mit HMDSO und HMDSN sind wie in Figur 4 dargestellt in einem ersten Schrankbereich 110 angeordnet. Von den Vorratsbehälter 112, 114 führen Grundgasleitungen 124, 125 bis in einen davon getrennten zweiten Schrankbereich 120, der als Warmbereich 120 bzw. Warmkammer 120 ausgebildet ist, wie in der allgemeinen Beschreibung erläutert. Die in diesem Warmbereich 120 verlaufenden Leitungen 124, 125, 131, 132, 133 und die in diesem Bereich angeordneten Dosiermittel 141, 142, 143, wie z.B. MFC`s, sollen auf einer Temperatur gehalten sein, die oberhalb der Siedetemperatur der in den Vorratsbehältern 112, 114 aufgenommenen Precursorflüssigkeiten liegen bzw. oberhalb der Temperaturen liegen sollen, auf denen die Precursorflüssigkeiten in den Vorratsbehältern 112, 114 gebracht werden. Bevorzugt soll ein zusätzlicher Temperaturunterschied von 5 °C eingestellt sein, d. h. der zweite Schrankbereich 120 bzw. der Warmbereich 120 soll auf eine um 5 °C höhere Temperatur gehalten sein, als die Siedetemperatur bzw. die Aufheiztemperatur.

Im rechten Bereich der Figur 5 ist angedeutet, dass drei Prozessgasmischungen 151, 152, 153 bereitgestellt werden sollen, wobei diese Prozessgasmischungen in nicht dargestellter Weise einer Beschichtungsanlage 10 zugeführt werden, z.B. über in Figur 3 dargestellte Leitungen mit den Ventilen 66 und 67, wobei für die dritte Prozessgasmischung eine weitere Leitung mit einem weiteren Ventil hinzutreten könnte.

Weiterhin ist in Figur 5 in einer als mögliche Variante aufzufassenden Anordnung eine Vakuumpumpe 160 dargestellt, die über jeweilige Schaltmittel, z.B. Magnetventile 161, 162, 163, Vakuum auf die Leitungen 131, 132, 133 geben kann, in denen die drei genannten Prozessgasmischungen 151 152, 153 aus der Gasversorgungsvorrichtung 100 herausgeführt werden. Auf diese Weise kann ein Bypassweg bereitgestellt werden, um nicht von der Beschichtungsvorrichtung 10 abgenommene Gasmengen abzusaugen, z.B. in den Phasen, in denen ein Behälterwechsel erfolgt, oder in den Phasen, in denen andere Prozessgasmischungen abgenommen werden. Solche Bypassleitungen sind im Stand der Technik vielfältig bekannt.

Die der Gasversorgungsvorrichtung 100 in gasförmiger Form zugeführten Grundgase (Argon, Sauerstoff) werden von diesen zugeordneten Dosiermitteln, beispielsweise MFC's 146, 147, 148, dosiert Mischbereichen 171, 172, 173 zugeführt. Im dargestellten Beispiel sind die MFC 146, 147, 148 diesen Grundgasen zugeordnet. Diese MFC 146, 147, 148 sind außerhalb des Warmbereiches 120 angeordnet, da diese MFC 146, 147, 148 nicht auf erhöhter Temperatur gehalten werden müssen, denn ein Kondensieren des geführten Gases kann nicht eintreten, denn die dort strömenden Gase liegen bei den üblichen Raumtemperaturen in Gasform vor. Die MFC 141, 142, 143, welche der Dosierung der Grundgase dienen, die nach Verdampfen aus den Precursorflüssigkeiten entstehen, sind hingegen im Warmbereich 120 angeordnet. Dies erfolgt, um ein Kondensieren dieser Grundgase in den Leitungen 131, 132, 1333 und/oder in den Dosiermitteln 141, 142, 143 zu verhindern.

Jedes der dargestellten MFC 141, 142, 143, 146, 147, 148 ist jeweils ausgestattet mit einer jeweiligen Steuerelektronik 145. Die jeweiligen Steuerelektroniken 145 der MFC 141, 142, 143 sind optional und mit Vorteil beabstandet von den davon gesteuerten MFC 141, 142, 143 angeordnet, siehe Anordnung im gestrichelte Bereich 180, und die Anordnung dieser beabstandet von den MFC 141, 142, 143 vorgesehenen Steuerelektroniken 145 erfolgt außerhalb des Warmbereiches 120. Zwar ist zu den MFC 146, 147, 148 dargestellt, dass deren Steuerelektronik 145 jeweils unmittelbar bei den MFC 146, 147, 148 verbleiben. Denkbar ist aber auch, dass auch diese Steuerelektroniken 145 beanstandet von den MFC 146, 147, 148 angeordnet werden und z.B. gemeinsam mit den anderen Steuerelektroniken 145 im Bereich 180 angeordnet werden, um dort eine Steuereinheit 180 mit allen Steuerelektroniken 145 der MFC 141, 142, 143, 146, 147, 148 auszubilden. Diese Steuereinheit 180 könnte z.B. klimatisiert ausgeführt sein und/oder in räumlicher Nähe zu der Steuereinrichtung 200 der Gasversorgungsvorrichtung 100 oder zu einer Steuereinrichtung der Beschichtungsanlage 10 angeordnet werden.

Wie weiterhin aus Figur 5 erkennbar, führen die Grundgasleitungen 102, 104 der Trägergase stromabwärts der MFC 146, 147, 148 in den Warmbereich hinein bis hin zu Mischbereichen 171, 172, 173, die als Kreuzungspunkte ausgeführt sind, in denen unterschiedliche Grundgase führende Grundgasleitungen zusammenlaufen. An diesem Kreuzungspunkten 171, 172, 173 werden Grundgase zusammengeführt, die einerseits bereits in gasförmiger Form vorlagen (Argon, Sauerstoff) und die andererseits durch Verdampfen von Precursorflüssigkeiten erzeugt wurden. Aus diesem Grunde ist das Anordnen dieser Mischbereiche 171, 172, 173 bzw. der Kreuzungspunkte im Warmbereich vorteilhaft, um auch in diesen Mischbereichen 171, 172, 173 und den in Strömungsrichtung nachfolgenden Leitungen ein Kondensieren zu vermeiden.

Figur 5 zeigt also beispielhaft einige erfindungsgemäße und verallgemeinerbare Aspekte, nämlich einerseits, dass ein Teil der Dosiermittel bzw. MFC innerhalb des Warmbereiches angeordnet ist und ein anderer Teil außerhalb des Warmbereichs. Bevorzugt und wie in Figur 5 dargestellt soll unterschieden werden zwischen den Dosiermitteln, die aus flüssigen Precursor erzeugten Grundgasen zugeordnet sind, welche nämlich im Warmbereich angeordnet werden, und den MFC, die Grundgasleitungen zugeordnet sind, in denen bereits gasförmig zugeführte Grundgase geführt sind, welche nämlich außerhalb des Warmbereiches angeordnet sind. Weiterhin sollen nach einem weiteren Aspekt die Steuerelektroniken der im Warmbereich aufgenommenen MFC beanstandet von den MFC außerhalb des Warmbereiches angeordnet sein. Als weiterer Aspekt kann der Figur 5 entnommen werden, dass nur diejenigen Leitungen und Dosiermittel innerhalb des Warmbereiches angeordnet sind, in denen aus flüssigen Precursern entstandene Grundgase geführt werden, während Leitungen und Dosiermittel außerhalb des Warmbereiches angeordnet werden können und in Figur 5 auch angeordnet sind, welche ausschließlich Grundgase führen, die bereits gasförmig vorliegen. Auf diese Weise kann der Warmbereich geringer dimensioniert ausgeführt werden und die MFC können übliche MFC sein, die bei üblicher Raumtemperatur zufriedenstellend arbeiten.

## Patentansprüche

1. Vorrichtung (100) zur Versorgung einer Anlage (10) zur Beschichtung von Werkstücken (5) mit für den Beschichtungsprozess benötigten Prozessgasen,
wobei die Vorrichtung wenigstens zwei Grundgasleitungen (124, 125; 102, 104) zum getrennten Führen von wenigstens zwei Grundgasen in einer Strömungsrichtung und wenigstens ein Mischmittel (171, 172, 173) zum Zusammenführen und Mischen von wenigstens zwei der Grundgase zu einem Gasgemisch aufweist,
wobei zur dosierten Zuführung der Grundgase zum Mischmittel (171, 172, 173) in den Grundgasleitungen (102, 104; 124, 125) in der Strömungsrichtung der zugeführten Grundgase vor dem Mischmittel (171, 172, 173) jeweils ein geregeltes Ventil, angeordnet ist, bevorzugt ein Massflow-Controller (MFC; 141, 142, 143; 146, 147, 148),
wobei die Vorrichtung zur Bereitstellung eines ersten Grundgases wenigstens einen Verdampfer (112, 114) aufweist, der eingerichtet und ausgebildet ist zur Überführung eines flüssigen Ausgangsfluides in den gasförmigen Zustand, wobei der Verdampfer (112, 114) hierzu insbesondere Heizmittel (115) zum Erwärmen des Ausgangsfluides mindestens bis zu dessen Siedetemperatur aufweist,
wobei die Vorrichtung zur Bereitstellung eines zweiten Grundgases angeschlossen ist an eine Zuführleitung (102, 104) für das Zuführen des zweiten Grundgases aus einer Gasquelle,
wobei die Vorrichtung einen von Wänden umgebenden Warmbereich (120) aufweist, der auf einer Temperatur größer oder gleich der Siedetemperatur gehalten ist,
wobei wenigstens eines der geregelten Ventile, bevorzugt eines der MFC (141, 142, 143), innerhalb dieses Warmbereiches (120) angeordnet ist,
**dadurch gekennzeichnet, dass**
wenigstens ein weiteres der geregelten Ventile, bevorzugt eines der MFC (146, 147, 148) außerhalb dieses Warmbereiches (120) angeordnet ist.

2. Vorrichtung (100) nach Anspruch 1, **dadurch gekennzeichnet, dass** die geregelten Ventile, bevorzugt die MFC (141, 142, 143; 146, 147, 148) jeweils eine Steuerelektronik (145) aufweisen, und die Steuerelektronik (145) des wenigstens einen im Warmbereich (120) angeordneten geregelten Ventils, bevorzugt die Steuerelektronik (145) des einen dort angeordneten MFC (141, 142, 143), außerhalb des Warmbereiches (120) angeordnet ist.

3. Vorrichtung (100) nach Anspruch 1 oder 2, wobei die Vorrichtung (100) zur Bereitstellung eines weiteren Grundgases einen weiteren Verdampfer (114, 112) aufweist, der eingerichtet und ausgebildet ist zur Überführung eines zweiten flüssigen Ausgangsfluides in den gasförmigen Zustand, wobei der Verdampfer (114, 112) hierzu insbesondere Heizmittel (115) zum Erwärmen des zweiten Ausgangsfluides mindestens bis zu dessen Siedetemperatur aufweist, wobei alle geregelten Ventile, bevorzugt alle MFC (141, 142, 143), in den Grundgasleitungen (124, 125) der aus den flüssigen Ausgangsfluiden entstandenen Grundgase im Warmbereich (120) angeordnet sind, und bevorzugt alle Steuerelektroniken (145) dieser geregelten Ventile, bevorzugt MFC (141, 142, 143), außerhalb des Warmbereiches (120) angeordnet sind.

4. Vorrichtung (100) nach einem der vorhergehenden Ansprüche, wobei die Vorrichtung eine weitere Zuführleitung (104, 102) für das Zuführen eines weiteren Grundgases aus einer Gasquelle aufweist, **dadurch gekennzeichnet, dass** alle geregelten Ventile, bevorzugt MFC (146, 147, 148), in den Grundgasleitungen (102, 104), in denen Grundgase aus einer Gasquelle geführt sind, außerhalb des Warmbereiches (120) angeordnet sind.

5. Vorrichtung (100) nach einem der vorhergehenden Ansprüche, **dadurch gekennzeichnet, dass** die Temperatur im Warmbereich (120) wenigstens 5 °C über der Siedetemperatur gehalten ist.

6. Vorrichtung (100) nach einem der vorhergehenden Ansprüche, **dadurch gekennzeichnet, dass** der Verdampfer (112, 114) oder jeder der Verdampfer (112, 114) ausgebildet ist, das Ausgangsfluid mindestens auf 10 °C, bevorzugt mindestens 15 °C und weiter bevorzugt mindestens 20 °C oberhalb dessen Siedetemperatur aufzuheizen, wobei die Temperatur im Warmbereich (120) bevorzugt wenigstens 5 °C oberhalb dieser Aufheiztemperatur gehalten ist.

7. Anlage (10) zur Beschichtung von Werkstücken (5), insbesondere zur Beschichtung von Innenwänden von Behältern (5), insbesondere mittels eines PECVD-Verfahrens, insbesondere mittels eines mikrowelleninduzierten PECVD-Verfahrens, mit einer Vorrichtung (100) zur Bereitstellung der für den Beschichtungsprozess benötigten Prozessgasen, wobei diese Vorrichtung (100) nach einem der vorhergehenden Ansprüche ausgebildet ist.

8. Verfahren zur Versorgung einer Anlage (10) zur Beschichtung von Werkstücken (5) mit für den Beschichtungsprozess benötigten Prozessgasen,
wobei wenigstens zwei Grundgase in wenigstens zwei Grundgasleitungen (102, 104; 124, 125) geführt werden bis zu einem Mischpunkt (171, 172, 173) und dort zu einem Gasgemisch zusammengeführt werden,
wobei das Zuführen dosiert erfolgt, indem geregelte Ventile, bevorzugt Massflow-Controller (MFC; 141, 142, 143; 146, 147, 148), in den Grundgasleitungen (102, 104; 124, 125) angeordnet werden,
wobei ein erstes Grundgas erzeugt wird durch Überführen eines flüssigen Ausgangsfluides in den gasförmigen Zustand, nämlich durch Erhitzen auf eine Temperatur oberhalb dessen Siedetemperatur,
wobei ein zweites Grundgas aus einer Gasquelle zugeführt wird,
wobei ein von Wänden umgebender Warmbereich (120) bereitgestellt wird, der auf einer Temperatur größer oder gleich der Siedetemperatur gehalten wird,
wobei das Zuführen des ersten Grundgases durch wenigstens ein erstes geregeltes Ventil, bevorzugt ein erstes MFC (141, 142, 143) erfolgt, welches innerhalb dieses Warmbereiches (120) angeordnet ist,
**dadurch gekennzeichnet, dass**
das Zuführen des zweiten Grundgases durch wenigstens ein weiteres geregeltes Ventil, bevorzugt MFC (146, 147, 148) erfolgt, welches außerhalb dieses Warmbereiches (120) angeordnet ist.

9. Verfahren nach Anspruch 8, **dadurch gekennzeichnet, dass** jedes geregelte Ventil, bevorzugt jedes MFC (141, 142, 143; 146, 147, 148), eine Steuerelektronik (145) aufweist, und die Steuerelektronik (145) des wenigstens einen im Warmbereich (120) angeordneten geregelten Ventils, bevorzugt MFC (141, 142, 143), außerhalb des Warmbereiches (120) angeordnet wird.

10. Verfahren nach Anspruch 8 oder 9, wobei ein weiteres Grundgas erzeugt wird durch Überführen eines zweiten flüssigen Ausgangsfluides in den gasförmigen Zustand, nämlich durch Erhitzen auf eine Temperatur oberhalb dessen Siedetemperatur, wobei das Zuführen aller Grundgase, die aus den flüssigen Ausgangsfluiden erzeugt werden, jeweils durch ein geregeltes Ventil, bevorzugt MFC (141, 142, 143) erfolgt, welche jeweils im Warmbereich (120) angeordnet sind, und bevorzugt alle Steuerelektroniken (125) dieser geregelten Ventile, bevorzugt MFC (141, 142, 143), außerhalb des Warmbereiches (120) angeordnet werden.

11. Verfahren nach einem der vorhergehenden Ansprüche 8-10, wobei ein weiteres Grundgas aus einer Gasquelle zugeführt wird, **dadurch gekennzeichnet, dass** das Zuführen aller Grundgase, die aus einer Gasquelle zugeführt werden, jeweils durch ein geregeltes Ventil, bevorzugt MFC (146, 147, 148) erfolgt, welche jeweils außerhalb des Warmbereiches (120) angeordnet werden.

12. Verfahren nach einem der vorhergehenden Ansprüche 8-11, **dadurch gekennzeichnet, dass** die Temperatur im Warmbereich (120) wenigstens 5 °C über der Siedetemperatur gehalten wird.

13. Verfahren nach einem der vorhergehenden Ansprüche 8-12, **dadurch gekennzeichnet, dass** das Ausgangsfluid oder jedes der Ausgangsfluide mindestens auf 10 °C, bevorzugt mindestens 15 °C und weiter bevorzugt mindestens 20 °C oberhalb dessen Siedetemperatur aufgeheizt wird, wobei die Temperatur im Warmbereich (120) bevorzugt wenigstens 5 °C oberhalb dieser Aufheiztemperatur gehalten wird.
